# EUROPÄISCHE PATENTSCHRIFT

(11) **EP 2 927 514 B1**
(45) Veröffentlichungstag und Bekanntmachung des Hinweises auf die Patenterteilung: **27.05.2020**
(21) Anmeldenummer: 15160451.9
(22) Anmeldetag: 24.03.2015
(51) Int. Cl.: F16B 21/06, G07C 9/00

(54) **ABDECKUNG EINER AUFNAHMEÖFFNUNG EINES AUFNAHMEFACHS**
COVERING OF A HOLDER OPENING OF A HOLDER COMPARTMENT
REVÊTEMENT D'UNE OUVERTURE DE RÉCEPTION D'UN COMPARTIMENT DE RÉCEPTION

(30) Priorität: 24.03.2014 DE 102014104023
(43) Veröffentlichungstag der Anmeldung: 07.10.2015
(73) Patentinhaber: Huf Hülsbeck & Fürst GmbH & Co. KG, 42551 Velbert (DE)
(72) Erfinder: Porada, Martin, 42109 Wuppertal (DE); Borgmann, Frank, 42283 Wuppertal (DE)
(74) Vertreter: Bals, Rüdiger

(56) Entgegenhaltungen:
- EP-A1- 1 130 879
- WO-A1-2010/052003
- DE-A1-102008 005 343
- DE-A1-102009 022 636
- DE-U1-202007 002 857
- US-A1- 2010 136 825

## Beschreibung

Die vorliegende Erfindung betrifft einen ID-Geber nach dem Oberbegriff von Anspruch 1 sowie ein Verfahren nach Anspruch 10 für das Öffnen einer Aufnahmeöffnung eines Aufnahmefachs.

Es ist bekannt, dass insbesondere ID-Geber für Fahrzeuge Aufnahmefächer für die Aufnahme weiterer Bauteile aufweisen. Dabei handelt es sich insbesondere um das Aufnahmefach für einen Stromspeicher, z. B. in Form einer Batterie. Da solche Bauteile, insbesondere in Form einer Batterie, austauschbar sein müssen, ist es notwendig, einen Zugang zu diesen Bauteilen in den Aufnahmeraum hinein zu gewährleisten. Hierfür sind solche Aufnahmeräume, welche auch als Batteriefächer bezeichnet werden, auch mit einer entsprechenden Aufnahmeöffnung versehen. Um einen Schutz des Aufnahmefachs und der darin enthaltenen Bauteile zu gewährleisten, ist üblicherweise eine Abdeckung in diese Aufnahmeöffnung hinein geklemmt. Hierfür sind in bekannter Weise wenigstens zwei Rastabschnitte vorgesehen, welche über eine entsprechende elastische Ausbildung gegen Rastflächen des Aufnahmefachs verrasten können.

Nachteilhaft bei den bekannten Lösungen von Abdeckungen für solche Aufnahmefächer ist es, dass diese relativ aufwendig entfernt werden müssen. So ist ein gleichzeitiges elastisches Verformen mehrerer, insbesondere aller Rastabschnitte notwendig, um die Verrastung zu lösen und dementsprechend die Abdeckung abzuheben. Hierfür sind häufig Krafteinwirkungen von unterschiedlichen Seiten notwendig. Dies führt dazu, dass ein Öffnungsvorgang der Abdeckung der Aufnahmeöffnung relativ aufwendig und insbesondere mit hoher motorischer Komplexität behaftet ist.

Aus dem Stand der Technik ist ein ID-Geber z.B. aus der WO 2010/052003 A1 oder der DE 10 2009 022636 A bekannt.

Es ist Aufgabe der vorliegenden Erfindung, die voranstehend beschriebenen Nachteile zumindest teilweise zu beheben. Insbesondere ist es Aufgabe der vorliegenden Erfindung, in kostengünstiger und einfacher Weise den Entriegelungsvorgang und damit die Öffnung der Aufnahmeöffnung zu ermöglichen.

Voranstehende Aufgabe wird gelöst durch einen ID-Geber mit den Merkmalen des Anspruchs 1 sowie ein Verfahren mit den Merkmalen des Anspruchs 10. Weitere Merkmale und Details der Erfindung ergeben sich aus den Unteransprüchen, der Beschreibung und den Zeichnungen. Dabei gelten Merkmale und Details, die im Zusammenhang mit der Abdeckung eines erfindungsgemäßen ID-Gebers beschrieben sind, selbstverständlich auch im Zusammenhang mit dem erfindungsgemäßen ID-Geber sowie dem erfindungsgemäßen Verfahren und jeweils umgekehrt, so dass bzgl. der Offenbarung zu den einzelnen Erfindungsaspekten stets wechselseitig Bezug genommen wird bzw. werden kann.

Eine Abdeckung eines erfindungsgemäßen ID-Gebers dient zur Abdeckung einer Aufnahmeöffnung eines Aufnahmefachs, insbesondere eines ID-Gebers für Fahrzeuge. Hierfür weist die Abdeckung einen Abdeckabschnitt zur wenigstens teilweisen Abdeckung der Aufnahmeöffnung und wenigstens zwei Rastabschnitte mit jeweils einer Rastfläche zur rastenden Anlage an einer Gegenrastfläche des Aufnahmefachs auf. Eine Abdeckung eines erfindungsgemäßen ID-Gebers zeichnet sich dadurch aus, dass zumindest ein Rastabschnitt als Entriegelungs-Rastabschnitt relativ zum Abdeckabschnitt bewegbar ausgebildet ist. Weiter ist zumindest ein Rastabschnitt als starrer Rastabschnitt ausgebildet, wobei der starre Rastabschnitt einen Rastwinkel zwischen der Rastfläche und der Horizontalen aufweist, welcher als spitzer Winkel ausgebildet ist.

Eine Abdeckung eines erfindungsgemäßen ID-Gebers basiert also auf bekannten Abdeckungen und weist wenigstens zwei Rastabschnitte auf. Eine Rastfläche kann dabei im Sinne der vorliegenden Erfindung eine beliebige Erstreckung aufweisen. Es ist jedoch bevorzugt, wenn die Rastfläche jeweils eine ebene oder im Wesentlichen ebene Erstreckung aufweist. Die Rastfunktionalität entsteht dabei durch die zumindest abschnittsweise Kontaktierung zwischen der jeweiligen Rastfläche und der Gegenrastfläche des Aufnahmefachs. Damit kann ein Reibschluss und/oder ein Formschluss zur Verfügung gestellt werden, welcher die verrastete Sicherung der Abdeckung in der Aufnahmeöffnung erlaubt.

Die Abdeckung der Aufnahmeöffnung erfolgt durch die Abdeckung zumindest teilweise. Selbstverständlich kann die Abdeckung vorzugsweise die gesamte Aufnahmeöffnung abdecken und somit den Zugang versperren. Hierzu kann zumindest die Abdeckung oder die Aufnahmeöffnung ein Dichtmittel aufweisen, welches für die Abdichtung der Kontaktfläche zwischen der Abdeckung und dem Aufnahmefach ausgebildet ist.

Erfindungsgemäß sind die wenigstens zwei Rastabschnitte in zwei unterschiedliche Funktionalitäten zu unterscheiden. So ist wenigstens ein Rastabschnitt als Entriegelungs-Rastabschnitt in einer bewegbaren Ausbildung vorgesehen. Dabei kann die Bewegbarkeit des Entriegelungs-Rastabschnitts frei gewählt werden. So sind Lagerungen denkbar, welche diesen Bewegungsspielraum für den Entriegelungs-Rastabschnitt zur Verfügung stellen. Bevorzugt ist es jedoch, wenn über einen später noch beschriebenen Elastizitätsabschnitt eine Verformung bzw. teilweise Verformung des Entriegelungs-Rastabschnitts diesen Bewegungsspielraum bietet. Insbesondere kann dieser Bewegungsspielraum zwei Endpositionen definieren. Das bedeutet, dass der Entriegelungs-Rastabschnitt insbesondere zwischen einer Freigabeposition und einer Rastposition bewegbar ausgebildet ist. Die Rastposition bezieht sich dabei auf eine Position des Entriegelungs-Rastabschnitts, in welchem dessen Rastfläche in einer rastenden Anlage an der Gegenrastfläche des Aufnahmefachs angeordnet ist. Die Freigabeposition des Entriegelungs-Rastabschnitts bezieht sich dementsprechend auf eine Position, in welcher diese rastende Anlage fehlt, so dass nun eine Freigabe für eine Öffnungsbewegung der Abdeckung vorliegt.

Ein entscheidender Kerngedanke der vorliegenden Erfindung ist die Ausbildung eines weiteren Rastabschnitts als starrer Rastabschnitt. Darunter ist zu verstehen, dass hier keine oder nur eine geringe flexible Ausbildung bzw. Elastizität für diesen Rastabschnitt erforderlich ist. Somit kann der zumindest eine starre Rastabschnitt auch als Neben-Rastabschnitt bezeichnet werden, dessen Beweglichkeit oder fehlende Beweglichkeit keinerlei Einfluss auf die Öffnungsbewegung hat. Ein starrer Rastabschnitt kann im Sinne der vorliegenden Erfindung also eine Beweglichkeit aufweisen, muss dies aber für die Öffnungsfunktionalität nicht.

Um sicher zu stellen, dass nun trotzdem eine Öffnungsbewegung, insbesondere eine Öffnungsrotation der Abdeckung zur Freigabe und Öffnung der Aufnahmeöffnung möglich wird, ist erfindungsgemäß eine spezielle Ausgestaltung der Rastfläche vorgesehen. Diese Rastfläche ist nun nicht, wie sonst üblich, entlang der Horizontalen angeordnet, sondern weist zu dieser einen spitzen Winkel auf. Dieser spitze Winkel ist vorzugsweise von der Horizontalen nach unten, also von dem Abdeckabschnitt weggerichtet. Handelt es sich bei dem Rastabschnitt um eine Ausführungsform, bei welcher eine Sekundärfläche im Wesentlichen senkrecht bzw. vertikal ausgerichtet ist, so führt dies dazu, dass die Summe aus dem Vertikalwinkel und dem Rastwinkel einen Gesamtwinkel von mehr als 90°, insbesondere im Bereich um circa 100° ausbildet. Es ist jedoch darauf hinzuweisen, dass eine solche Sekundärfläche nicht zwangsläufig vorgesehen sein muss, bzw. nicht zwangsläufig im Rahmen der vorliegenden Erfindung senkrecht stehen muss.

Für die Ausrichtungsbestimmung des Rastwinkels ist der Bezug zur Horizontalen wichtig. Unter der Horizontalen ist eine Ausrichtung einer Ebene zu verstehen, welche horizontal bzw. waagerecht mit Bezug auf die Ausrichtung der Abdeckung bzw. des ID-Gebers zu verstehen ist. Insbesondere wenn der Abdeckabschnitt eine ebene oder im Wesentlichen ebene Erstreckung aufweist, so ist diese Horizontale in dieser Ebene bzw. parallel zu dieser Ebene angeordnet. Wird vorzugsweise für die Öffnung der Abdeckung eine Öffnungsrotation durchgeführt, so ist die Horizontale vorzugsweise auch parallel zu dieser Rotationsachse der Öffnungsrotation angeordnet.

Das Ausbilden des Rastwinkels in erfindungsgemäßer Weise in spitzwinkliger Art führt dazu, dass zum Einen in der verrasteten Position des Entriegelungs-Rastabschnitts eine ausreichende Sicherung in dieser geschlossenen Position für die Abdeckung erfolgt. Zum anderen ist nach einem Bewegen des Entriegelungs-Rastabschnitts insbesondere in seine Freigabeposition jedoch ein erleichtertes Öffnen der Abdeckung möglich. Während dieses Öffnungsvorgangs, insbesondere während einer Öffnungsrotation der Abdeckung, kann nun ein erleichtertes Abgleiten bzw. sogar vollständiges Abheben der Rastfläche des starren Rastabschnitts von der entsprechenden Gegenrastfläche des Aufnahmefachs erfolgen. Während bei bekannten Abdeckungen noch eine manuelle Bewegung des starren Rastabschnitts durch eine elastische Ausbildung desselben notwendig war, kann nun die notwendige Entriegelungsbewegung auf den zumindest einen Entriegelungs-Rastabschnitt fokussiert werden. Es ist daher auch bevorzugt, dass genau ein Rastabschnitt als Entriegelungs-Rastabschnitt ausgebildet ist. Damit wird es möglich, mit einer einzelnen Entriegelungsbewegung am Entriegelungs-Rastabschnitt die Freigabe zu ermöglichen, um die Abdeckung insbesondere in Form einer Öffnungsrotation zu öffnen.

Es kann von Vorteil sein, wenn bei einer Abdeckung eines erfindungsgemäßen ID-Gebers der Rastwinkel im Bereich von größer oder gleich ca. 10° und kleiner oder gleich ca. 60° ausgebildet ist, bevorzugt im Bereich zwischen ca. 15° und ca. 45°, besonders bevorzugt im Bereich zwischen ca. 18° und ca. 35°. Ist zusätzlich eine Sekundärfläche vorgesehen mit einer senkrechten oder im Wesentlichen senkrechten Ausbildung, so führt die Summe für den Gesamtwinkel, welcher den Rastwinkel enthält, zu einem Wert von größer oder gleich 100°. Bei einem Rastwinkel von größer oder gleich circa 10° werden die erfindungsgemäßen Vorteile mit hoher Sicherheit erzielt. Gleichzeitig ist bevorzugt, dass der Rastwinkel eine Obergrenze von circa 60° nicht überschreitet. Damit wird sichergestellt, dass eine ausreichend hohe Rastkraft für die Verrastung der Rastfläche an der Gegenrastfläche verbleibt. Somit wird ein Kompromiss erzielt zwischen einer erleichterten Öffnungsbewegung der Abdeckung einerseits und einer sicheren Verrastung in der geschlossenen Position der Abdeckung andererseits.

Vorteilhaft ist es ebenfalls, wenn bei einer Abdeckung eines erfindungsgemäßen ID-Gebers der Entriegelungs-Rastabschnitt und der starre Rastabschnitt eine zumindest teilweise entgegengesetzte Ausrichtung der Rastflächen aufweisen. Es ist bevorzugt, wenn die jeweiligen Rastabschnitte die Rastflächen in Form von hervorstehenden Rastnasen aufweisen. Diese Rastnasen weisen dementsprechend eine Ausrichtung auf. Um eine definierte und eindeutige Positionierung der Abdeckung innerhalb bzw. relativ zur Aufnahmeöffnung zu gewährleisten, ist nun die zumindest teilweise entgegengesetzte Ausrichtung dieser Rastflächen bzw. der Rastnasen vorgesehen. Damit kann sozusagen ein gegenseitiges Verspannen zur Verfügung gestellt werden, welches Relativbewegungen der Abdeckungen zum Aufnahmefach in der eingesetzten und verschließenden Position reduziert oder sogar vollständig vermeidet. Dabei kann es vorteilhaft sein, wenn diese entgegengesetzte Ausrichtung mit einer geometrischen Positionierung erfolgt, die einem Übermaß bezogen auf das Aufnahmefach entspricht. Dieses insbesondere gering ausgebildete Übermaß führt dazu, dass die Abdeckung bzw. die jeweiligen Rastabschnitte sozusagen in das Aufnahmefach eingepresst werden, so dass nur ein geringes Spie! bzw. kein Spiel aufgrund eines Presssitzes mehr bleibt. Es ist jedoch bevorzugt, wenn ein geringes Spiel verbleibt, um die beschriebene Bewegungsfunktionalität für den Öffnungsvorgang mit größerer Freigängigkeit zur Verfügung stellen zu können. Insbesondere stehen die einzelnen Rastflächen sogar direkt entgegengesetzt zueinander, also in einem Winkel von circa 180°.

Vorteilhaft ist es ebenfalls, wenn bei einer Abdeckung eines erfindungsgemäßen ID-Gebers der Entriegefungs-Rastabschnitt für die bewegbare Ausbildung einen Elastizitätsabschnitt aufweist, welcher insbesondere einstückig mit dem Abdeckabschnitt ausgebildet ist. Die einstückige Ausbildung erfolgt insbesondere monolithisch bzw. integral für die beiden Bauteile. Somit sind der Elastizitätsabschnitt und der Abdeckabschnitt demnach insbesondere stoffschlüssig bzw. materialschlüssig miteinander ausgebildet. Der Elastizitätsabschnitt wurde bereits angesprochen und führt dazu, dass der Bewegungsspielraum für den Entriegelungs-Rastabschnitt nun als flexible Bewegung ausgebildet werden kann. Mit anderen Worten, durch Einwirken einer Entriegelungskraft wird der Elastizitätsabschnitt des Entriegelungs-Rastabschnitts elastisch verformt. Sobald die Entriegelungskraft wieder entfernt wird, wird durch die elastischen Rückstellkräfte der Entriegelungs-Rastabschnitt wieder in seine ursprüngliche Form zurückbewegt. Somit kann dieser Elastizitätsabschnitt zum einen als Bewegungsgeber bzw. Lagerung, zum anderen als die später noch erläuterte Vorspannvorrichtung beschrieben werden. Je nach Art und Konstruktion dieses Elastizitätsabschnitts kann sogar eine Ausbildung als Filmscharnier denkbar sein. Dies führt zu einer besonders kostengünstigen und einfachen Ausführungsform. Insbesondere findet diese Ausführungsform Einsatz bei Abdeckungen und Rastabschnitten aus Kunststoffmaterial.

Eine Abdeckung eines erfindungsgemäßen ID-Gebers lässt sich dahingehend weiterbilden, dass der Entriegelungs-Rastabschnitt zwischen wenigstens einer Rastposition und einer Freigabeposition bewegbar ausgebildet ist. Dabei beaufschlagt eine Vorspannvorrichtung den Entriegelungs-Rastabschnitt in Richtung der Rastposition mit einer Kraft. Die Vorspannvorrichtung kann dabei z. B. als separate Federvorrichtung ausgebildet sein. Es ist jedoch bevorzugt, wenn die Vorspannvorrichtung als Teilelement integral bzw. einstückig oder monolithisch mit dem Entriegelungs-Rastabschnitt ausgebildet ist. Dies bezieht sich insbesondere auf eine Ausführungsform, bei welcher der Entriegelungs-Rastabschnitt einen Elastizitätsabschnitt aufweist. Die Vorspannvorrichtung führt also dazu, dass beim Schließen der Abdeckung, also beim Bewegen in die Abdeckposition, eine automatische Bewegung des Entriegelungs-Rastabschnitts in seine Rastposition erfolgt. Die Bewegung in die Rastposition ist dabei vorzugsweise quer, insbesondere senkrecht zur Bewegungsrichtung der Abdeckung in die Abdeckposition ausgerichtet. Es handelt sich also insbesondere um eine lineare oder um eine kippende bzw. um eine horizontale Achse rotierende Schließ- und Öffnungsbewegung für die Abdeckung. In dieser Rastposition erfolgt darüber hinaus vorzugsweise eine Vorspannung und damit eine Erhöhung der Rastkraft. Dies führt zu einer weiteren Sicherung der Abdeckung eines erfindungsgemäßen ID-Gebers. Auch kann vorzugsweise über eine definierte Vorspannvorrichtung eine definierte Entriegelungskraft korreliert werden, um in vorgegebener Weise die Entriegelung durchführen zu können.

Ein weiterer Vorteil ist erzielbar, wenn bei einer Abdeckung eines erfindungsgemäßen ID-Gebers die Rastabschnitte einstückig, insbesondere integral, mit dem Abdeckabschnitt ausgebildet sind. Insbesondere sind die Rastabschnitte monolithisch mit dem Abdeckabschnitt ausgebildet. So kann die gesamte Abdeckung insbesondere als Kunststoffspritzteil ausgebildet sein. So wird es möglich, kostengünstig und einfach die Herstellung der Abdeckung eines erfindungsgemäßen ID-Gebers zu erzielen. Auch eine Ausbildung eines Elastizitätsabschnitts, wie er bereits erläutert worden ist, ist in einstückiger bzw. integraler Weise z. B. mithilfe eines Spritzgussverfahrens denkbar.

Vorteilhaft ist es darüber hinaus, wenn bei einer Abdeckung eines erfindungsgemäßen ID-Gebers die Rastabschnitte mit dem Abdeckabschnitt einen Winkel zwischen circa 80° und circa 100° einschließen. Mit anderen Worten, die Rastabschnitte erstrecken sich senkrecht bzw. im Wesentlichen senkrecht vom Abdeckabschnitt nach unten. Üblicherweise wird der Abdeckabschnitt eine ebene oder leicht gekrümmte und damit im Wesentlichen ebene Erstreckung aufweisen. Die Rastabschnitte erstrecken sich also in das Aufnahmefach hinein, um dort die entsprechende Verrastung durchführen zu können. Dabei ist nicht zwangsläufig eine Gleichheit der entsprechenden Winkel für alle Rastabschnitte notwendig. Es ist jedoch von Vorteil, wenn alle Winkel der einzelnen Rastabschnitte zueinander gleich oder im Wesentlichen gleich ausgebildet sind.

Vorteilhaft ist es darüber hinaus, wenn bei einer Abdeckung eines erfindungsgemäßen ID-Gebers der Abdeckabschnitt und/oder wenigstens einer der Rastabschnitte eine Faserverstärkung aufweist, insbesondere aus einem faserverstärkten Kunststoff ausgebildet ist. Darunter ist ein Material zu verstehen, welches trotz leichter Bauweise eine verstärkte mechanische Widerstandskraft aufweist. Als Faserverstärkung können Glasfasern und/oder Karbonfasern, jedoch auch einzelne Formen von Kunststofffasern eingesetzt werden. Als Matrixmaterial können dabei ebenfalls Kunststoffe oder andere Materialien einsetzbar sein. Die Faserverstärkung kann insbesondere lokal vorgesehen sein, um entsprechende Funktionalitäten auszugestalten. So kann bspw. der starre Rastabschnitt komplett faserverstärkt ausgebildet sein. Durch bewusstes Weglassen von Faserverstärkung in einzelnen Abschnitten des Entriegelungs-Rastabschnitts kann in definierter Weise der Elastizitätsabschnitt zur Verfügung gestellt werden.

Ein weiterer Vorteil ist erzielbar, wenn bei einer Abdeckung eines erfindungsgemäßen ID-Gebers der Entriegelungs-Rastabschnitt eine Handhabungsfläche aufweist für die Einbringung einer Entriegelungskraft für die Bewegung des Entriegelungs-Rastabschnitts. Im einfachsten Fall handelt es sich dabei um eine Fläche, insbesondere eine ebene Fläche, auf welche ein entsprechendes Entriegelungsmittel einwirken kann. Das Entriegelungsmittel kann dabei z. B. ein Teil eines Fingers einer Person sein. Auch Bauteile, wie z. B. ein Stift, ein Geldstück oder ein Notschlüssel eines Fahrzeugs können als Entriegelungsmittel einsetzbar sein. Bevorzugt ist die Ausbildung der Handhabungsfläche insbesondere in geometrischer Weise korrelierend mit der geometrischen Ausbildung des Entriegelungsmittels ausgebildet. Die Handhabungsfläche kann oberhalb der Rastfläche des Entriegelungs-Rastabschnitts angeordnet sein, um eine möglichst geringe geometrische Erstreckung dieses Rastabschnitts zu erzielen. Auch ist es im Rahmen der vorliegenden Erfindung denkbar, dass die Handhabungsfläche unterhalb der Rastfläche angeordnet ist, um einen größeren Hebel für die Durchführung der Bewegung in eine Freigabeposition mit verringerter Kraft zu ermöglichen. Die Begriffe darunter und darüber beziehen sich dabei auf die Korrelation zu einem oberhalb der Rastfläche angeordneten Abdeckabschnitt.

Ein Gegenstand der vorliegenden Erfindung ist ein ID-Geber für ein Fahrzeug, aufweisend ein Aufnahmefach für die Aufnahme insbesondere eines Energiespeichers. Ein erfindungsgemäßer ID-Geber zeichnet sich dadurch aus, dass das Aufnahmefach eine Aufnahmeöffnung aufweist, welche durch eine Abdeckung abgedeckt ist und die Merkmale von Anspruch 1 aufweist. Damit bringt ein erfindungsgemäßer ID-Geber die gleichen Vorteile mit sich, wie sie ausführlich mit Bezug auf eine Abdeckung eines erfindungsgemäßen ID-Gebers erläutert worden sind. Unter einem ID-Geber ist erfindungsgemäß ein elektronischer Schlüssel, insbesondere ein Funkschlüssel eines Fahrzeugs, zu verstehen. Ein Stromspeicher ist im Sinne der vorliegenden Erfindung insbesondere eine auswechselbare Batterie. Selbstverständlich kann ein solches Aufnahmefach jedoch auch für andere austauschbare Bauteile, z. B. eine Steuerungsplatine, vorgesehen sein.

Weiterer Gegenstand der vorliegenden Erfindung ist ein Verfahren für das Öffnen einer Aufnahmeöffnung eines Aufnahmefachs eines erfindungsgemäßen ID-Gebers, aufweisend die folgenden Schritte:
- Bewegen eines Entriegelungs-Rastabschnitts einer Abdeckung aus einer Rastposition in eine Freigabeposition,
- Bewegen der Abdeckung aus einer Abdeckposition in eine Öffnungsposition unter Abgleiten einer Rastfläche eines starren Rastabschnitts an einer Gegenrastfläche des Aufnahmefachs.

Durch die Verwendung eines erfindungsgemäßen ID-Gebers führt ein erfindungsgemäßes Verfahren zu den gleichen Vorteilen, wie sie ausführlich mit Bezug auf den erfindungsgemäßen ID-Geber bzw. mit Bezug auf die Abdeckung eines erfindungsgemäßen ID-Gebers erläutert worden sind. Beim Bewegen des Entriegelungs-Rastabschnitts in seine Freigabeposition erfolgt vorzugsweise eine Krafteinwirkung, welche eine Vorspannvorrichtung überwindet. Anschließend kann die Öffnungsbewegung insbesondere als Öffnungsrotation für die Abdeckung aus der Abdeckposition in die Öffnungsposition erfolgen. Das Abgleiten der Rastfläche an der jeweiligen Gegenrastfläche des Aufnahmefachs für den starren Rastabschnitt erfolgt über zumindest einen Teil dieser Öffnungsbewegung. Ein unerwünschtes Sperren, welches ebenfalls eine Bewegbarkeit bzw. Verformbarkeit des starren Rastabschnitts erfordern würde, kann auf diese Weise erfindungsgemäß verhindert werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Es zeigen schematisch:
- Figur 1: eine erste Ausführungsform einer Abdeckung eines erfindungsgemäßen ID-Gebers,
- Figur 2: die Ausführungsform der Figur 1 eingesetzt in einen erfindungsgemäßen ID-Geber,
- Figur 3: die Ausführungsform gemäß Figur 2 unter Einwirkung eines Handhabungsmittels,
- Figur 4: eine Darstellung der Ausführungsform der Figuren 2 und 3 während der Öffnungsbewegung der Abdeckung,
- Figur 5: die Ausführungsform der Figuren 2 bis 4 nach der Durchführung der Öffnungsbewegung,
- Figur 6: eine weitere Ausführungsform einer Abdeckung eines erfindungsgemäßen ID-Gebers,
- Figur 7: eine weitere Ausführungsform einer Abdeckung eines erfindungsgemäßen ID-Gebers und
- Figur 8: eine Ausführungsform eines erfindungsgemäßen ID-Gebers.

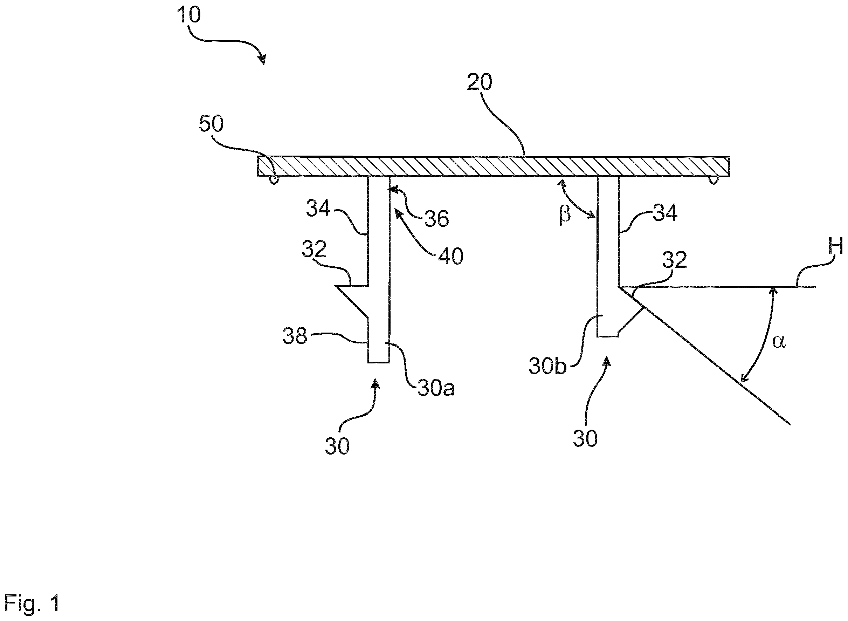

Die Figur 1 zeigt eine erste Ausführungsform einer Abdeckung 10. Diese ist mit einem Abdeckabschnitt 20 versehen, welcher eine entsprechende Aufnahmeöffnung 110 eines Aufnahmefachs 100 vollständig abdeckt.

Von dem im Wesentlichen als ebene Fläche ausgebildeten Abdeckabschnitt 20 erstrecken sich hier zwei Rastabschnitte 30 senkrecht, also mit einem Winkel von circa 90° nach unten. Diese beiden Rastabschnitte 30 unterscheiden sich voneinander hinsichtlich ihrer Ausbildung. So ist der linke Rastabschnitt 30 als Entriegelungs-Rastabschnitt 30a ausgebildet. Über einen Elastizitätsabschnitt 36 ist eine Bewegbarkeit des Entriegelungs-Rastabschnitts 30a insbesondere von links nach rechts gegeben. Gleichzeitig sind an einer Rastnase eine Rastfläche 32 und eine Sekundärfläche 34 vorgesehen, welche die Rastfunktion erfüllen können. Der gegenüberliegende rechte Rastabschnitt 30 ist als starrer Rastabschnitt 30b ausgebildet. Dieser ist erfindungsgemäß nun mit einem Rastwinkel α zur Horizontalen H ausgebildet, welcher spitzwinklig geformt ist. Die Rastfläche 32 ist dementsprechend nach unten geneigt. Bei einer wie hier senkrecht ausgebildeten Sekundärfläche 34 führt dies zu einem Gesamtwinkel, welcher den Rastwinkel α inkludiert, von größer als 90°, insbesondere von circa 100°. Die beiden Rastabschnitte 30 erstrecken sich bei dieser Ausführungsform im Wesentlichen senkrecht von dem Abdeckabschnitt nach unten, also mit einem Winkel β von ca. 90°. Weiter weist die Abdeckung der Ausführungsform der Figur 1 ein Dichtmittel 50 auf, welches für die Abdichtung der Kontaktfläche zu dem Aufnahmefach 100 ausgebildet ist.

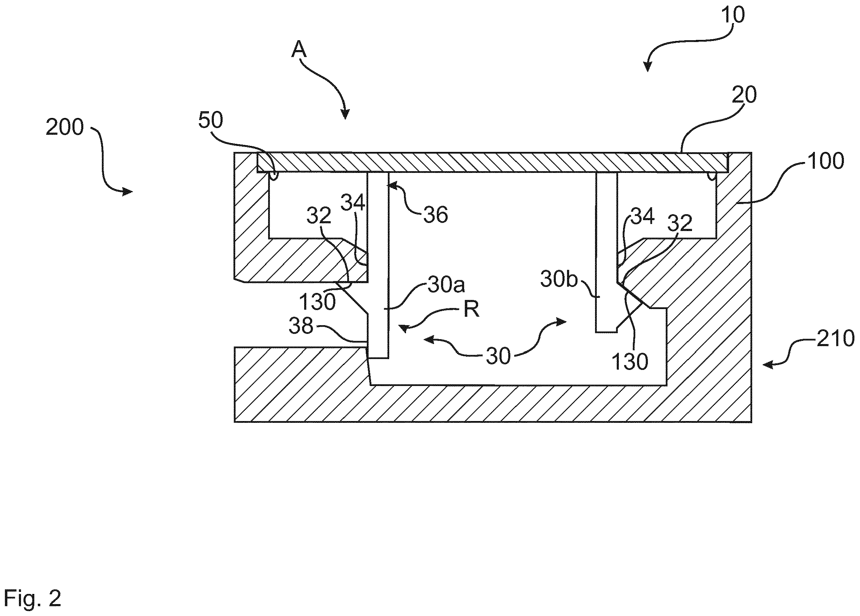

Anhand der Figuren 2 bis 5 soll nun der Öffnungsvorgang eines erfindungsgemäßen Verfahrens mit einer Abdeckung 10 bei einem erfindungsgemäßen ID-Geber 200 erläutert werden. In Figur 2 befindet sich die Abdeckung 10 in der Abdeckposition A. Der Abdeckabschnitt 20 deckt also die Aufnahmeöffnung 110 vollständig ab. Um ein unerwünschtes Entfernen der Abdeckung 10 zu vermeiden, sind die beiden Rastabschnitte 30 in ihrer verrasteten Position. Insbesondere sind die jeweiligen Rastflächen 32 kontaktierend zur jeweiligen Gegenrastfläche 130 des Aufnahmefachs 100 angeordnet. Das Aufnahmefach 100 ist hier als Teil eines Gehäuses 210 des ID-Gebers 200 ausgebildet.

Wie der Figur 2 zu entnehmen ist, sind neben den Rastflächen 32 auch Sekundärflächen 34 hier vorzugsweise ebenfalls in kontaktierender Anlage an entsprechenden Kontaktflächen des Aufnahmefachs 100 angeordnet. So wird in formschlüssiger und/oder rastschlüssiger Weise eine Sicherung der Abdeckung 10 gegen unerwünschtes Öffnen des Aufnahmefachs 100 gegeben.

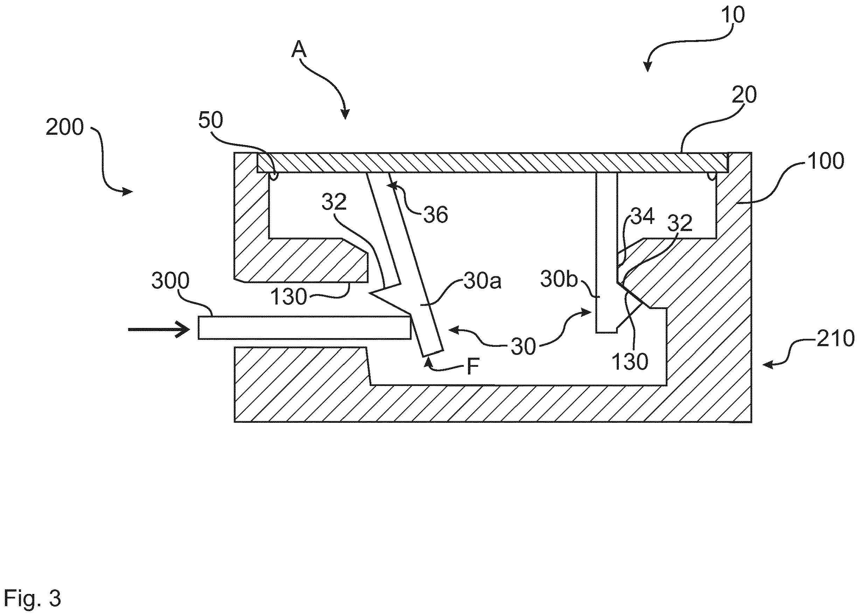

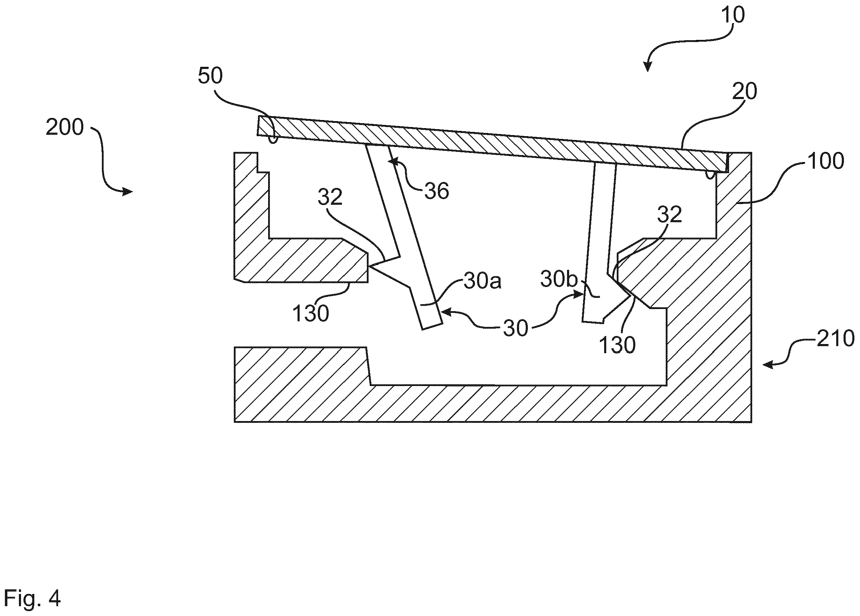

Wird ein Öffnen gewünscht, muss ein Handhabungsmittel 300, welches auch als Entriegelungsmittel bezeichnet werden kann, eine Bewegung des Entriegelungs-Rastabschnitts 30a durchführen. Dies ist in Figur 3 gezeigt. Über eine entsprechende Öffnung wird das Handhabungsmittel 300 eingeführt und kann nun mit der Handhabungsfläche 38 zusammenwirken. Dabei wird der Entriegelungs-Rastabschnitt 30a über einen im Wesentlichen als Filmscharnier wirkenden Elastizitätsabschnitt 36 nach rechts bewegt. Dies führt zum Lösen der entsprechenden Rastfläche 32 von der Gegenrastfläche 130, wie dies die Figur 3 zeigt. Dies führt nun dazu, dass ein Anheben der Abdeckung 20 in rotierender Öffnungsbewegung erfolgen kann, wie dies die Figur 4 zeigt. Durch die Anstellung mithilfe des Rastwinkels α für die Rastfläche 32 des starren Rastabschnitts 30b erfolgt nun ein Abgleiten der Rastfläche 32 an der zugehörigen Gegenrastfläche 130. Eine Bewegbarkeit oder Elastizität dieses starren Rastabschnitts 30b ist nicht mehr erforderlich.

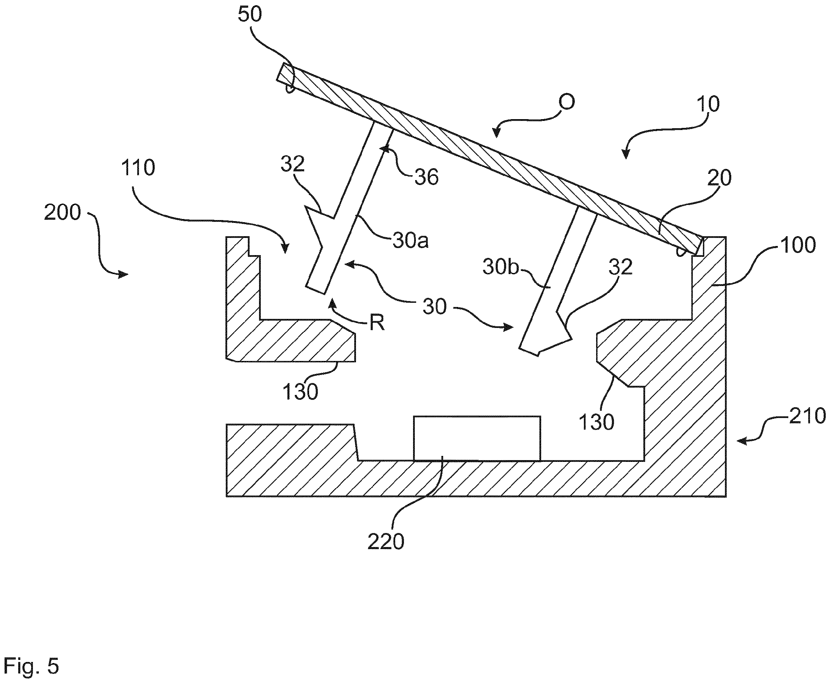

Das Ende der Öffnungsbewegung, insbesondere dieser Öffnungsrotation der Abdeckung 10 ist in Figur 5 dargestellt. Hier befindet sich der Abdeckabschnitt 20 bzw. die Abdeckung 10 in der Öffnungsposition O. Durch die elastischen Rückstellkräfte des Elastizitätsabschnitts 36, welcher hier dementsprechend als Vorspannvorrichtung 40 wirkt, wurde der Entriegelungs-Rastabschnitt 30a wieder in seine Rastposition R zurückgeführt. Schematisch ist hier ein bereits eingesetzter Energiespeicher 220 dargestellt.

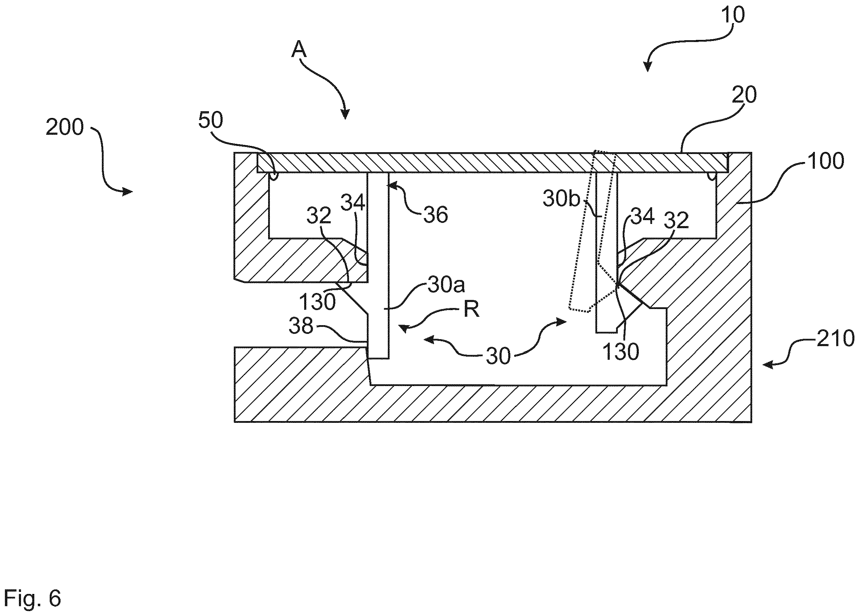

In Figur 6 ist eine Variante dargestellt, welche bei einer gleichen Abdeckung 10 eine andere geometrische Form des Aufnahmefachs 100 beinhaltet. Hier ist gut zu erkennen, dass keine vollflächige Anlage der Rastfläche 32 an der Gegenrastfläche 130 für den starren Rastabschnitt 30b notwendig ist. Vielmehr kann sich diese Kontaktierung sogar auf eine linienförmige Berührung reduzieren. Es ist jedoch für die Sicherheit des Rastsitzes bevorzugt, wenn zumindest in Teilabschnitten eine flächige Kontaktierung zwischen der jeweiligen Rastfläche 32 und der entsprechenden Gegenrastfläche 130 vorliegt.

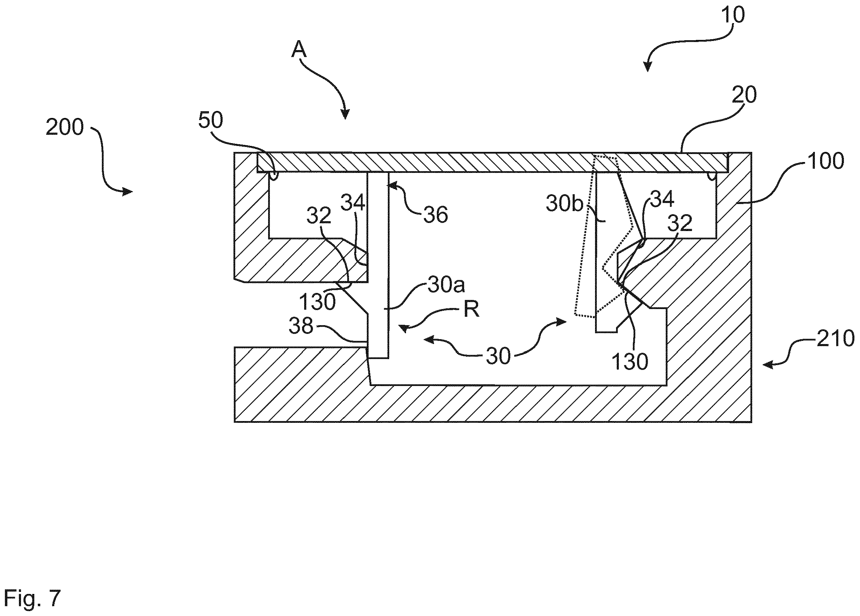

Figur 7 zeigt eine Möglichkeit, bei welcher die Sekundärfläche 34 keine senkrechte bzw. vertikale Erstreckung aufweist. Dies führt zu einem noch stärkeren und damit sichereren Formschluss in der Abdeckposition A der Abdeckung 10. Durch die erfindungsgemäße Ausbildung des Rastwinkels als spitzer Winkel kann jedoch auch bei einer solchen komplexeren geometrischen Form des starren Rastabschnitts 30b der erfindungsgemäße Kerngedanke erzielt werden. So unterbleibt auch hier ein Sperren des starren Rastabschnitts 30b. Die entsprechende Bewegungsmöglichkeit während einer Öffnungsrotation wird dabei sowohl in Figur 6 als auch in Figur 7 durch eine entsprechende Punktlinie für den starren Rastabschnitt 30b angezeigt.

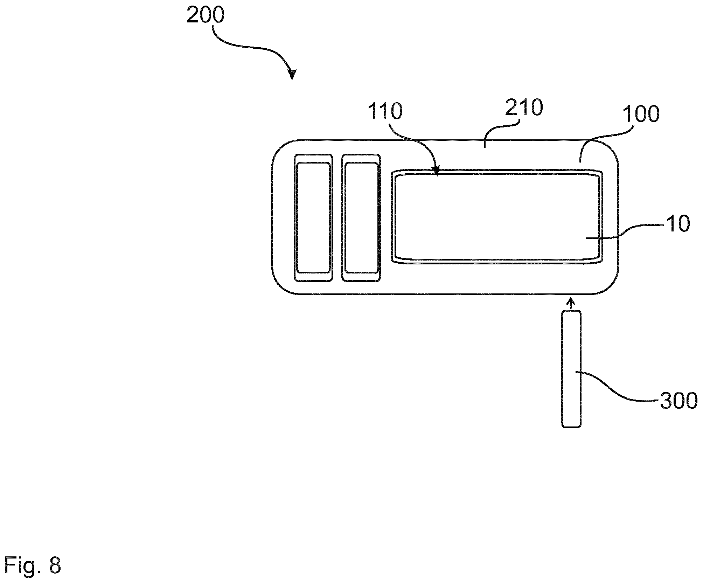

Figur 8 zeigt schematisch eine mögliche Ausführungsform eines erfindungsgemäßen ID-Gebers 200. Ein Handhabungsmittel 300, welches auch als Entriegelungsmittel bezeichnet werden kann, kann hier von der Seite eingreifen und die entsprechende Entriegelungsbewegung durchführen, wie sie anhand der Figuren 2 bis 5 erläutert worden ist. Die Abdeckung 10 kann dann geöffnet werden, so dass die Aufnahmeöffnung 110 des Aufnahmefachs 100 innerhalb des Gehäuses 210 des ID-Gebers 200 geöffnet ist. Innerhalb dieses Aufnahmefachs 100 kann dann ein Stromspeicher, z. B. in Form einer Batterie, angeordnet werden bzw. ausgetauscht werden.

Die voranstehende Erläuterung der Ausführungsformen beschreibt die vorliegende Erfindung ausschließlich im Rahmen von Beispielen.

### Bezugszeichenliste

- 10: Abdeckung
- 20: Abdeckabschnitt
- 30: Rastabschnitt
- 30a: Entriegelungs-Rastabschnitt
- 30b: starrer Rastabschnitt
- 32: Rastfläche
- 34: Sekundärfläche
- 36: Elastizitätsabschnitt
- 38: Handhabungsfläche
- 40: Vorspannvorrichtung
- 50: Dichtmittel

- 100: Aufnahmefach
- 110: Aufnahmeöffnung
- 130: Gegenrastfläche

- 200: ID-Geber
- 210: Gehäuse
- 220: Energiespeicher

- 300: Handhabungsmittel

- R: Rastposition
- F: Freigabeposition

- A: Abdeckposition
- O: Öffnungsposition

- H: Horizontale
- α: Rastwinkel
- β: Winkel

## Patentansprüche

1. ID-Geber (200) für ein Fahrzeug, aufweisend ein Aufnahmefach (100) für die Aufnahme insbesondere eines Energiespeichers (220),
wobei das Aufnahmefach (100) eine Aufnahmeöffnung (110) aufweist, welche durch eine Abdeckung (10) abgedeckt ist, wobei die Abdeckung (10) einen Abdeckabschnitt (20) zur wenigstens teilweisen Abdeckung der Aufnahmeöffnung (110) und wenigstens zwei Rastabschnitte (30) mit jeweils einer Rastfläche (32) zur rastenden Anlage an einer Gegenrastfläche (130) des Aufnahmefachs (100) aufweist,
**dadurch gekennzeichnet,**
**dass** zumindest ein Rastabschnitt (30) als Entriegelungs-Rastabschnitt (30a) relativ zum Abdeckabschnitt (20) bewegbar ausgebildet ist und
zumindest ein Rastabschnitt (30) als starrer Rastabschnitt (30b) ausgebildet ist, wobei der starre Rastabschnitt (30b) einen Rastwinkel (α) zwischen der Rastfläche (32) und der Horizontalen (H) aufweist, welcher als spitzer Winkel ausgebildet ist, wobei die Horizontale (H) eine Ausrichtung einer Ebene ist, welche horizontal mit Bezug auf die Ausrichtung der Abdeckung (10) ist.

2. ID-Geber (200) nach Anspruch 1,
**dadurch gekennzeichnet,**
**dass** Rastwinkel (α) im Bereich von größer oder gleich ca. 10° und kleiner oder gleich ca. 60° ausgebildet ist, bevorzugt im Bereich zwischen ca. 15° und ca. 45°, besonders bevorzugt im Bereich zwischen ca. 18° und ca. 35°.

3. ID-Geber (200) nach einem der vorangegangenen Ansprüche,
**dadurch gekennzeichnet,**
**dass** der Entriegelungs-Rastabschnitt (30a) und der starre Rastabschnitt (30b) eine zumindest teilweise entgegengesetzte Ausrichtung der Rastflächen (32) aufweisen.

4. ID-Geber (200) nach einem der vorangegangenen Ansprüche,
**dadurch gekennzeichnet,**
**dass** der Entriegelungs-Rastabschnitt (30a) für die bewegbare Ausbildung einen Elastizitätsabschnitt (36) aufweist, welcher insbesondere einstückig mit dem Abdeckabschnitt (20) ausgebildet ist.

5. ID-Geber (200) nach einem der vorangegangenen Ansprüche,
**dadurch gekennzeichnet,**
**dass** der Entriegelungs-Rastabschnitt (30a) zwischen wenigstens einer Rastposition (R) und einer Freigabeposition (F) bewegbar ausgebildet ist, wobei eine Vorspannvorrichtung (40) den Entriegelungs-Rastabschnitt (30a) in Richtung der Rastposition (R) mit einer Kraft beaufschlagt.

6. ID-Geber (200) nach einem der vorangegangenen Ansprüche,
**dadurch gekennzeichnet,**
**dass** die Rastabschnitte (30) einstückig, insbesondere integral, mit dem Abdeckabschnitt (20) ausgebildet sind.

7. ID-Geber (200) nach einem der vorangegangenen Ansprüche,
**dadurch gekennzeichnet,**
**dass** die Rastabschnitte (30) mit dem Abdeckabschnitt (20) einen Winkel (β) zwischen ca. 80° und ca. 100° einschließen.

8. ID-Geber (200) nach einem der vorangegangenen Ansprüche,
**dadurch gekennzeichnet,**
**dass** der Abdeckabschnitt (20) und/oder wenigstens einer der Rastabschnitte (30) eine Faserverstärkung aufweist, insbesondere aus faserverstärktem Kunststoff ausgebildet ist.

9. ID-Geber (200) nach einem der vorangegangenen Ansprüche,
**dadurch gekennzeichnet,**
**dass** der Entriegelungs-Rastabschnitt (30a) eine Handhabungsfläche (38) aufweist für die Einbringung einer Entriegelungskraft für die Bewegung des Entriegefungs-Rastabschnitts (30a).

10. Verfahren für das Öffnen einer Aufnahmeöffnung (110) eines Aufnahmefachs (100) eines ID-Gebers (200) mit den Merkmalen nach einem der Ansprüche 1 bis 9, aufweisend die folgenden Schritte:
- Bewegen eines Entriegelungs-Rastabschnitts (30a) einer Abdeckung (10) aus einer Rastposition (R) in eine Freigabeposition (F),
- Bewegen der Abdeckung (20) aus einer Abdeckposition (A) in eine Öffnungsposition (O) und Abgleiten einer Rastfläche (32) eines starren Rastabschnitts (30b) an einer Gegenrastfläche (130) des Aufnahmefachs (100).

## Claims

1. ID transmitter (200) for a vehicle, comprising a receiving compartment (100) for receiving in particular an energy storage device (220),
the receiving compartment (100) having a receiving opening (110) which is covered by a cover (10), the cover (10) having a covering section (20) for at least partially covering the receiving opening (110) and at least two latching sections (30) each having a latching surface (32) for latching contact with a counter-latching surface (130) of the receiving compartment (100),
**characterized in that,**
at least one latching section (30) is designed as an unlocking latching section (30a) which can be moved relative to the cover section (20), and
at least one latching section (30) is formed as a rigid latching section (30b), wherein the rigid latching section (30b) has a latching angle (α) between the latching surface (32) and the horizontal (H), which is formed as an acute angle, wherein the horizontal (H) is an orientation of a plane which is horizontal with respect to the orientation of the cover (10).

2. ID transponder (200) according to claim 1,
**characterized in that,**
the latching angle (α) is formed in the range of greater than or equal to approx. 10° and less than or equal to approx. 60°, preferably in the range between approx. 15° and approx. 45°, particularly preferably in the range between approx. 18° and approx. 35°.

3. ID transponder (200) according to one of the preceding claims,
**characterized in that,**
the unlocking latching section (30a) and the rigid latching section (30b) have an at least partially opposite orientation of the latching surfaces (32).

4. ID transponder (200) according to one of the preceding claims,
**characterized in that,**
the unlocking latching section (30a) for the movable formation has an elasticity section (36) which is formed in particular in one piece with the cover section (20).

5. ID transponder (200) according to one of the preceding claims,
**characterized in that,**
the unlocking latching section (30a) is designed to be movable between at least one latching position (R) and a release position (F), a pretensioning device (40) applying a force to the unlocking latching section (30a) in the direction of the latching position (R).

6. ID transponder (200) according to one of the preceding claims,
**characterized in that,**
the locking sections (30) are formed in one piece, in particular integrally, with the cover section (20).

7. ID transponder (200) according to one of the preceding claims,
**characterized in that,**
the latching sections (30) form an angle (β) between approximately 80° and approximately 100° with the cover section (20).

8. ID transponder (200) according to one of the preceding claims,
**characterized in that,**
the cover section (20) and/or at least one of the latching sections (30) has a fibre reinforcement, in particular is formed from fibre-reinforced plastic.

9. ID transponder (200) according to one of the preceding claims,
**characterized in that,**
the unlocking latching section (30a) has a handling surface (38) for the introduction of an unlocking force for the movement of the unlocking latching section (30a).

10. Method for opening a receiving opening (110) of a receiving compartment (100) of an ID transmitter (200) having the features according to one of claims 1 to 9, comprising the following steps:
- moving an unlocking latching section (30a) of a cover (10) from a latching position (R) to a release position (F),
- moving the cover (20) from a cover position (A) into an opening position (O) and sliding a latching surface (32) of a rigid latching section (30b) on a counter-latching surface (130) of the receiving compartment (100).

## Revendications

1. Emetteur d'identification (200) pour un véhicule, comprenant un compartiment de réception (100) pour recevoir notamment un dispositif de stockage d'énergie (220),
le compartiment de réception (100) présentant une ouverture de réception (110) qui est recouverte par un couvercle (10), le couvercle (10) présentant une section de recouvrement (20) pour recouvrir au moins partiellement l'ouverture de réception (110) et au moins deux sections d'encliquetage (30) présentant chacune une surface d'encliquetage (32) pour un contact d'encliquetage avec une surface de contre-encliquetage (130) du compartiment de réception (100),
**caractérisé en ce**
**qu'**au moins une section d'encliquetage (30) est conçue comme une section d'encliquetage de déverrouillage (30a) qui peut être déplacée par rapport à la section de recouvrement (20), et
au moins une section d'encliquetage (30) est formée comme une section d'encliquetage rigide (30b), dans laquelle la section d'encliquetage rigide (30b) a un angle d'encliquetage (α) entre la surface d'encliquetage (32) et l'horizontale (H), qui est formée comme un angle aigu, où l'horizontale (H) est une orientation d'un plan qui est horizontal par rapport à l'orientation de la couvercle (10).

2. Emetteur d'identification (200) selon la revendication 1,
**caractérisé en ce que**
l'angle d'encliquetage (α) est formé dans la plage supérieure ou égale à environ 10° et inférieure ou égale à environ 60°, de préférence dans la plage comprise entre environ 15° et environ 45°, et plus particulièrement de préférence dans la plage comprise entre environ 18° et environ 35°.

3. Emetteur d'identification (200) selon l'une des revendications précédentes,
**caractérisé en ce que**
la section d'encliquetage de déverrouillage (30a) et la section d'encliquetage rigide (30b) ont une orientation au moins partiellement opposée des surfaces d'encliquetage (32).

4. Emetteur d'identification (200) selon l'une des revendications précédentes,
**caractérisé en ce que**
la section d'encliquetage de déverrouillage (30a) pour la formation mobile présente une section élastique (36) qui est formée en particulier d'une seule pièce avec la section de recouvrement (20).

5. Emetteur d'identification (200) selon l'une des revendications précédentes,
**caractérisé en ce que**
la section d'encliquetage de déverrouillage (30a) est conçue pour être mobile entre au moins une position d'enclenchement (R) et une position de déclenchement (F), un dispositif de précontrainte (40) appliquant une force à la section d'encliquetage de déverrouillage (30a) en direction de la position d'enclenchement (R).

6. Emetteur d'identification (200) selon l'une des revendications précédentes,
**caractérisé en ce que**
les sections d'encliquetage (30) sont formées d'une seule pièce, en particulier d'un seul tenant, avec la section de recouvrement (20).

7. Emetteur d'identification (200) selon l'une des revendications précédentes,
**caractérisé en ce que**
les sections d'encliquetage (30) forment un angle (β) compris entre environ 80° et environ 100° avec la section de couverture (20).

8. Emetteur d'identification (200) selon l'une des revendications précédentes,
**caractérisé en ce que**
la section de couverture (20) et/ou au moins une des sections d'encliquetage (30) est renforcée par des fibres, notamment en plastique renforcé de fibres.

9. Emetteur d'identification (200) selon l'une des revendications précédentes,
**caractérisé en ce que**
la partie d'encliquetage de déverrouillage (30a) comporte une surface de manipulation (38) pour l'introduction d'une force de déverrouillage pour le mouvement de la partie d'encliquetage de déverrouillage (30a).

10. Procédé d'ouverture d'une ouverture de réception (110) d'un compartiment de réception (100) d'un émetteur d'identification (200) présentant les caractéristiques selon l'une des revendications 1 à 9, comprenant les étapes suivantes :
- déplacement d'une partie d'encliquetage de déverrouillage (30a) d'un couvercle (10) d'une position d'enclenchement (R) à une position de déclenchement (F),
- déplacer le couvercle (20) d'une position de couverture (A) à une position d'ouverture (O) et faire glisser une surface d'encliquetage (32) d'une section d'encliquetage rigide (30b) sur une surface de contre-encliquetage (130) du compartiment de réception (100).
